# EUROPEAN PATENT SPECIFICATION

(11) **EP 0 506 304 B1**
(45) Date of publication and mention of the grant of the patent: **19.06.1996**
(21) Application number: 92302398.0
(22) Date of filing: 19.03.1992
(51) Int. Cl.: C23C 2/02, C23G 5/00

(54) **Method and apparatus for hot-dipping steel strip**
Verfahren und Vorrichtung zum Heissmetallisieren eines Stahlbandes
Procédé et appareil de revêtement par immersion à chaud d'une bande d'acier

(30) Priority: 26.03.1991 JP 86169/91
(43) Date of publication of application: 30.09.1992
(73) Proprietor: NISSHIN STEEL CO., LTD., Chiyoda-ku Tokyo 100 (JP)
(72) Inventor: Fukui, Yasushi, c/o Tekko Kenkyusho, Sakai-shi, Osaka (JP); Miono, Tadaaki, c/o Tekko Kenkyusho, Sakai-shi, Osaka (JP); Nakamoto, Kazunari, c/o Tekko Kenkyusho, Sakai-shi, Osaka (JP); Yoshii, Tsuguyasu, c/o Tekko Kenkyusho, Sakai-shi, Osaka (JP)
(74) Representative: BATCHELLOR, KIRK & CO.

(56) References cited:
- EP-A- 0 313 154
- EP-A- 0 397 952
- DE-C- 665 540
- CHEMICAL ABSTRACTS, vol. 99, no. 12, September 1983, Columbus, Ohio, US; abstract no. 92091A, NIPPON KOKAN: 'apparatus for acceleration of surface reduction of steel strip for galvanisation' page 243 ;column 99 ;
- Applied Physics A; Solids and Surfaces vol. A51, no. 3, September 1990, Berlin, DE, pages 238-251

## Description

The present invention relates to a method and an apparatus for continuously hot-dipping steel strip, wherein a pretreatment of the steel is improved e.g. prior to subsequent plating.

Hot dipping apparatus for steel strip is known, with a pretreating device for removing an oxide film on the steel strip before plating, thereby improving wettability of the steel and preventing the formation of bare spots on the steel strip. In the pretreating device, the steel strip is heated to anneal and remove combustible impurities at the same time. Thereafter, the steel strip is reduced by reducing gas.

However, in the case that the steel contains easily oxidizable elements such as chromium, silicon and aluminum, which steel is for example stainless steel, the oxide film can not be removed by the reducing gas. Consequently, the pretreated steel strip has low wettability.

The hot dipping may involve intermetallic reaction, e.g. metallic plating such as aluminium alloy plating and the reaction can be influenced by the easily oxidizable elements. Therefore, defects such as bare spots are liable to occur on the steel containing easily oxidizable elements.

Such a steel strip containing easily oxidizable elements can be plated by vacuum deposition, if the strip is heated.

If the steel strip containing easily oxidizable elements of the steel strip is electroplated before the hot dipping, the wettability of the strip is improved, thereby providing a product without defects. However, such a method renders the manufacturing process complicated, thereby increasing the manufacturing cost.

The document Applied Physics A : Solids and surfaces A51 (1990) September, No 3, pp 238 - 250 discloses a method for removing surface layers of a solid substrate by ion beam bombardment.

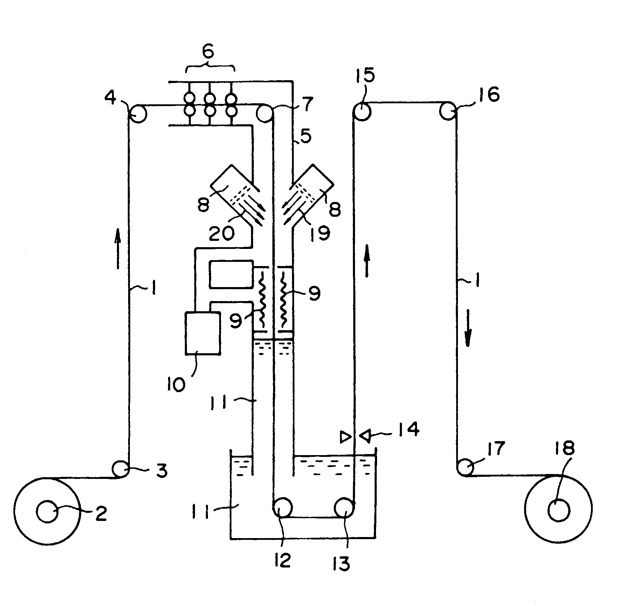

EP-A-0 397 952 discloses (i) in Figure 1 thereof a series of vacuum chambers through which a steel strip is successively passed in a horizontal direction and is deflected downwardly into a metal coating bath. A seal roll chamber is provided at the outlet of the vacuum chamber which the steel strip encounters after activation, and (ii) in Figure 3 an apparatus including a vacuum chamber together with magnet units, anodes, a turning roller and a metal coating bath which is similarly used for coating metal.

An object of the present invention is to provide a hot d ipping method and apparatus in which the surface of a steel strip is activated by sputtering-etching, thereby developing the wettability of the steel strip and substantially preventing formation of bare spots in the plating surface. In such fashion a surface oxide layer comprising one or more of aluminium, silicon or chromium oxides can be removed.

According to a first aspect of the present invention, there is provided a method of hot-dip coating a steel strip comprising:
providing a vacuum chamber which is defined by a sealed inlet at an upper end thereof which is adapted to receive and feed a steel strip and an outlet at the bottom end thereof, said outlet being immersed below the level of coating metal contained in a coating metal bath,
feeding a steel strip through said sealed inlet into said vacuum chamber and then carrying said steel strip downwards towards said outlet, whilst maintaining a vacuum within said chamber between said inlet and outlet,
activating the surface of said steel strip by sputter-etching irradiation of ion beams whilst the strip is in said vacuum chamber between the sealed inlet and said level of coating metal,
passing the activated steel strip from said vacuum chamber outlet directly into said coating metal bath to contact said coating metal, and
subsequently removing the metal-coated steel strip from said coating metal bath.

During sputtering-etching, if the temperature of the steel is lower than the temperature for the hot-dipping plating, the steel is preferably heated simultaneously.

In a second aspect of the present invention, we also provide apparatus for hot-dip coating a steel strip comprising:
a vacuum chamber which is defined by a sealed inlet at an upper end thereof which is adapted to receive and feed a steel strip and an outlet portion at the bottom end thereof, said outlet portion being immersed below the level of coating metal contained in a coating metal bath,
evacuation means connected to said chamber between said sealed inlet and outlet,
said chamber being arranged to permit a steel strip to be carried downwards through said vacuum chamber and to contact said coating metal by passing through said outlet portion,
ion beam ejecting means provided in said vacuum chamber above said outlet portion, to be capable of sputter-etching at least one surface of said steel sheet by irradiation thereof with ion beams, and
the arrangement of vacuum chamber, outlet portion and coating metal bath being such that upon application of vacuum to said chamber, coating metal is caused to rise into said outlet portion to separate the interior of said vacuum chamber from the atmosphere.

The vacuum chamber preferably has an ion beam ejecting device provided on opposite sides of a path line for the steel strip.

Any elements or molecules can be used for the ion beam for sputtering-etching. However, it is advantageous to use an ion beam of argon in consideration of easy handling, low cost, corrosion resistance after plating, and high speed treatment. In the sputtering-etching, ion beams impact the surface of the steel strip to splash atoms thereon by sputtering effect and etch the surface. Consequently, the oxide film of easily oxidizable elements is removed from the surface of the steel strip.

Even if argon gas leaks from the ejecting device into the vacuum chamber, the surface of the steel is maintained in a clean condition until the steel strip is dipped in the hot dipping bath.

A part of kinetic energy of the ion beam impacted to the steel strip changes to heat energy. As a result, the temperature of the steel strip may well increase for the hot dipping. If the temperature of the steel is insufficient, the steel strip can be heated by heaters in the vacuum chamber.

In order that the invention may be illustrated and readily carried into effect, preferred embodiments thereof are now described by way of non-limiting example only, with reference to the accompanying single figure.

The single figure attached is a schematic illustration showing a hot dipping apparatus according to the present invention.

Referring to the drawing, a steel strip 1 is fed from a pay off reel 2 to a vacuum chamber 5 through deflector rollers 3 and 4. A sealing device 6 of a roller type is provided in the vacuum chamber 5 adjacent to an inlet thereof. The vacuum chamber 5 is further provided with a deflector roller 7 for downwardly guiding the steel strip 1, ion beam ejecting devices 8, and heaters 9 both of which are provided on opposite sides of the path of the steel strip. A vacuum pump 10 is communicated with the vacuum chamber 5 to maintain the pressure in the chamber 5 to a predetermined reducing atmosphere. An outlet of the chamber 5 is immersed in a hot dipping bath 11. The bath 11 also serves as a sealing device for the outlet of the chamber 5. The steel strip 1 is heated by the heaters 9 to the same temperature as the bath 11.

In the bath 11, immersion rollers 12 and 13 are disposed to guide the strip in the bath. The steel strip 1 is guided in the upper direction by the roller 13. The plating thickness is adjusted by a gas wiping device 14. The steel strip 1 is fed to a reel 18 through deflector rollers 15, 16 and 17 and wound thereon.

In order to perform sputtering-etching, the air in the chamber 5 is discharged to provide a low pressure of about 1X10⁻³Pa with the vacuum pump 10. Argon ion beams 19 and 20 are ejected from the ejecting devices 8 to the steel strip 1 for performing the sputtering-etching. During the operation, the temperature of the steel strip 1 is increased by the ion beams. If the temperature is insufficient to the plating, the heaters 9 are operated to heat the steel strip 1.

### EXAMPLE

A degreased steel strip of SUS 430 stainless steel (finished material at 2B, having width of 100 mm and thickness of 0.5 mm) was plated with aluminium alloy by hot dipping under the conditions shown in table 1. The temperature of the steel strip 1 was controlled to 650°C by the heaters 9 before immersing in the bath.

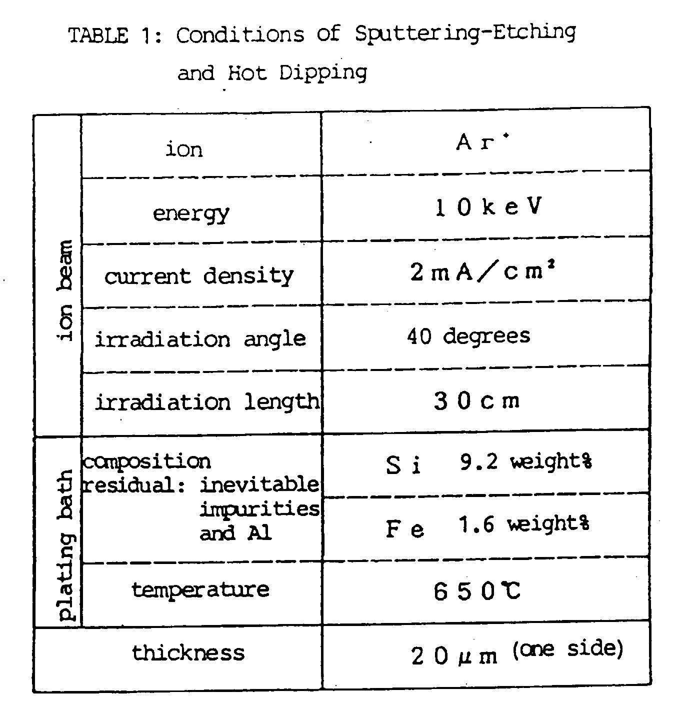

The plating layer formed on the steel strip was examined to investigate bare spot ratio and adhesion thereof. The result is shown in table 2. The bare spot ratio represents bare spot area per 0.05 m². The plating adhesion was investigated by two bending tests. In the first test, the steel strip was bent at 180 degrees until the opposite bent portions engage with each other (0t bending). In the second test, the steel strip was bent at 180 degrees by interposing another steel strip having the same thickness there-between (1t bending). Thereafter, a piece of a cellophane tape was stuck on the bent portion. Then, the tape is removed therefrom and the peeling off of the plating layer was examined. In the table, a mark ⓞ represents no peeling at 0t bending. A mark ○ represents the fact that a part of the plating layer is peeled off at 0t bending and not peeled at 1t bending. A mark Δ represents that a part of the plating layer is peeled off at 1t bending, and a mark x represents that the entire plating layer is peeled off at 1t bending.

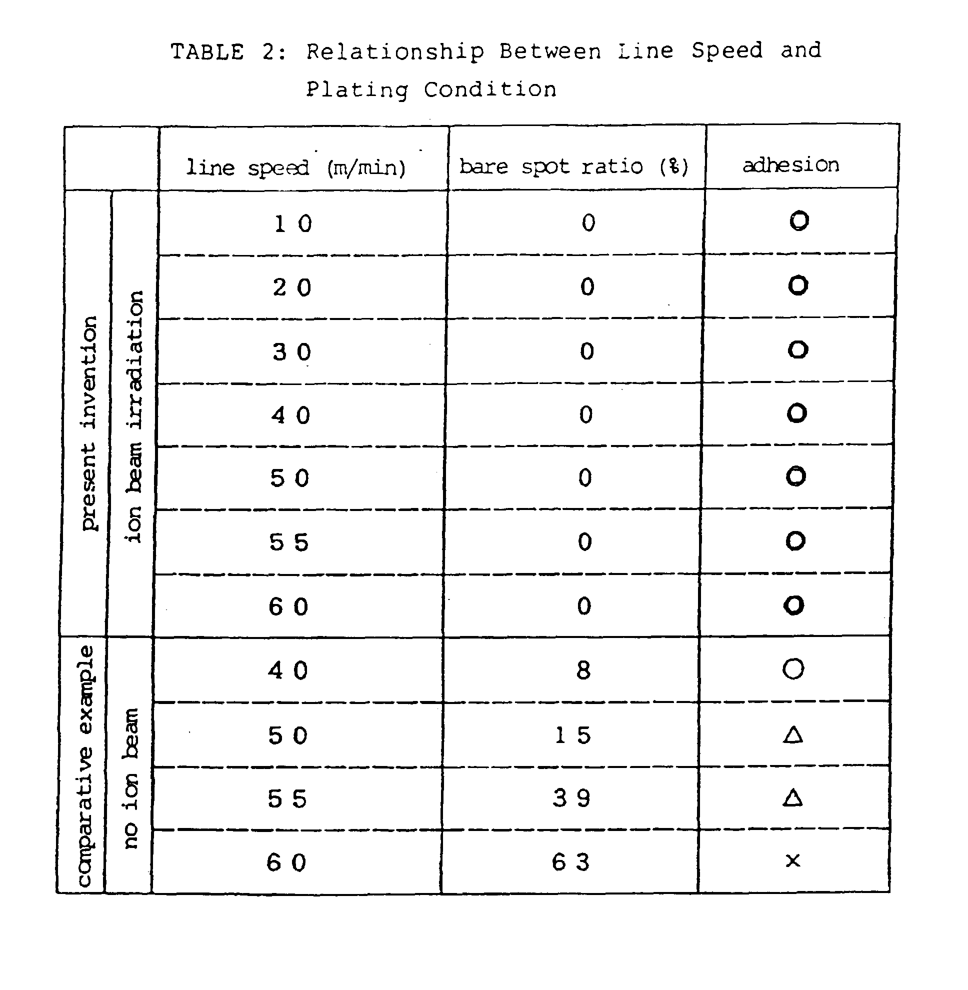

From the table 2, it will be seen that if the steel strip is pretreated by sputtering-etching with ion beams, the steel strip is plated with a good adhesion without bare spot at a high operating speed. To the contrary, the comparative examples have bare spots. The bare spot ratio increases with the operating speed.

In accordance with the present invention, the surface of the steel strip to be hot-dipped is cleaned by sputtering-etching with the ion beam. Since the atoms on the surface of the steel strip are removed by collision of the ion beam, the steel including easily oxidizable elements is sufficiently activated. As a result, it is possible to hot-dip the steel strip with improved adhesion and substantially no bare spots. The pretreating apparatus of the present invention can reduce the length of the line of the pretreatment so that starting or stopping of the apparatus can be easily performed. The steel produced can be useful in subsequent manufacturing operations.

## Claims

1. A method of hot-dip coating a steel strip comprising:
providing a vacuum chamber which is defined by a sealed inlet at an upper end thereof which is adapted to receive and feed a steel strip and an outlet at the bottom end thereof, said outlet being immersed below the level of coating metal contained in a coating metal bath,
feeding a steel strip through said sealed inlet into said vacuum chamber and then carrying said steel strip downwards towards said outlet, whilst maintaining a vacuum within said chamber between said inlet and outlet,
activating the surface of said steel strip by sputter-etching irradiation of ion beams whilst the strip is in said vacuum chamber between the sealed inlet and said level of coating metal,
passing the activated steel strip from said vacuum chamber outlet directly into said coating metal bath to contact said coating metal, and
subsequently removing the metal-coated steel strip from said coating metal bath.

2. A method as claimed in claim 1 wherein said steel strip is heated to a temperature suitable for hot-dip coating, and is then introduced in the activated and heated state into said coating metal bath.

3. A method as claimed in claim 1 or 2 wherein the ion beams are derived from ionised Argon gas.

4. A method as claimed in any preceding claim wherein the steel strip includes at least one of the following oxides on its surface-chromium oxide, silicon oxide and aluminium oxide.

5. A method as claimed in any preceding claim wherein the steel strip comprises stainless steel.

6. Apparatus for hot-dip coating a steel strip comprising:
a vacuum chamber which is defined by a sealed inlet at an upper end thereof which is adapted to receive and feed a steel strip and an outlet portion at the bottom end thereof, said outlet portion being immersed below the level of coating metal contained in a coating metal bath,
evacuation means connected to said chamber between said sealed inlet and outlet,
said chamber being arranged to permit a steel strip to be carried downwards through said vacuum chamber and to contact said coating metal by passing through said outlet portion,
ion beam ejecting means provided in said vacuum chamber above said outlet portion, to be capable of sputter-etching at least one surface of said steel sheet by irradiation thereof with ion beams, and
the arrangement of vacuum chamber, outlet portion and coating metal bath being such that upon application of vacuum to said chamber, coating metal is caused to rise into said outlet portion to separate the interior of said vacuum chamber from the atmosphere.

7. Apparatus according to claim 6, wherein a pair of ion beam ejecting devices are provided on opposite sides of the vacuum chamber for activating opposite surfaces of a steel sheet during travel thereof inside said vacuum chamber.

8. Apparatus as claimed in claim 6 or 7 wherein heating means are additionally provided for heating a steel strip to a temperature suitable for hot-dipping.

## Patentansprüche

1. Verfahren zum Warm-Tauchbeschichten eines Stahlbandes, bei dem man
eine Vakuumkammer vorsieht, die von einem abgedichteten Eingang an ihrem zur Aufnahme und Zuführung des Stahlbandes ausgebildeten oberen Ende und einem Ausgang an ihrem unteren Ende begrenzt ist, wobei der Ausgang unter das Niveau des in einem Beschichtungsmetallbad enthaltenen Beschichtungsmetalls eingetaucht ist,
das Stahlband durch den abgedichteten Eingang in die Vakuumkammer einführt und dann abwärts zu dem Ausgang hin fährt, wobei in der Kammer zwischen dem Eingang und dem Ausgang ein Vakuum aufrechterhalten wird,
die Oberfläche des Stahlbandes durch Sprüh-Ätzbestrahlung mit Ionenstrahlen aktiviert, während sich das Band in der Vakuumkammer zwischen dem abgedichteten Eingang und dem Niveau des Beschichtungsmetalls befindet,
das aktivierte Stahlband von dem Ausgang der Vakuumkammer zur Berührung mit dem Beschichtungsmetall direkt in das Beschichtungsmetallbad führt, und
anschließend das metallbeschichtete Stahlband aus dem Beschichtungsmetallbad entfernt.

2. Verfahren nach Anspruch 1, bei dem man das Stahlband auf eine für die Warm-Tauchbeschichtung geeignete Temperatur erhitzt und dann in dem aktivierten und erhitzten Zustand in das Beschichtungsmetallbad einführt.

3. Verfahren nach Anspruch 1 oder 2, bei dem die Ionenstrahlen aus einem ionisierten Argongas gebildet werden.

4. Verfahren nach einem vorhergehenden Anspruch, bei dem das Stahlband auf seiner Oberfläche wenigstens eins der Oxide Chromoxid, Siliziumoxid und Aluminiumoxid enthält.

5. Verfahren nach einem vorhergehenden Anspruch, bei dem das Stahlband Edelstahl enthält.

6. Vorrichtung zur Warm-Tauchbeschichtung eines Stahlbandes mit
einer Vakuumkammer, die von einem abgedichteten Eingang an ihrem zur Aufnahme und Zuführung des Stahlbandes ausgebildeten oberen Endes und einem Ausgangsteil an ihrem unteren Ende begrenzt ist, wobei der Ausgangsteil unter das Niveau des in einem Beschichtungsmetallbad enthaltenen Beschichtungsmetalls eingetaucht ist,
Evakuierungseinrichtungen, die zwischen dem abgedichteten Eingang und dem Ausgang an die Kammer angeschlossen sind,
wobei die Kammer so ausgebildet ist, daß ein Stahlband abwärts durch die Vakuumkammer laufen und nach Passieren des genannten Ausgangsteils mit dem Beschichtungsmetall in Berührung kommen kann,
in der Vakuumkammer über dem Ausgangsteil vorgesehenen Ionenstrahleinrichtungen, durch die wenigstens eine Oberfläche des Stahlbleches durch Bestrahlung mit Ionenstrahlen der Sprüh-Ätzung unterzogen werden kann, und
wobei die Ausbildung der Vakuumkammer, des Austrittsteils und des Beschichtungsmetallbades derart ist, daß das Beschichtungsmetall beim Anlegen von Vakuum an die Kammer veranlaßt wird, in das genannte Ausgangsteil zu steigen, um das Innere der Vakuumkammer vonder Atmosphäre abzutrennen.

7. Vorrichtung nach Anspruch 6, bei der ein Paar Ionenstrahleinrichtungen auf gegenüberliegenden Seiten der Vakuumkammer vorgesehen sind, um die entgegengesetzten Seiten des Stahlbleches während ihres Durchlaufs in der Vakuumkammer zu aktivieren.

8. Vorrichtung nach Anspruch 6 oder 7, bei der zusätzlich Erhitzungseinrichtungen vorgesehen sind, um das Stahlband auf eine für das Warm-Tauchen geeignete Temperatur zu erhitzen.

## Revendications

1. Procédé de revêtement par immersion à chaud d'une bande d'acier, comprenant les étapes consistant à :
disposer une chambre à vide qui est définie par une entrée étanche à une extrémité supérieure de celle-ci qui est adaptée pour recevoir et délivrer une bande d'acier et une sortie à l'extrémité inférieure de celle-ci, ladite sortie étant immergée en dessous du niveau du métal de placage se trouvant dans un bain de placage,
introduire une bande d'acier par l'intermédiaire de ladite entrée étanche dans ladite chambre à vide, et ensuite amener ladite bande d'acier vers le bas en direction de ladite sortie, tout en maintenant un vide à l'intérieur de ladite chambre entre ladite entrée et ladite sortie,
activer la surface de ladite bande d'acier à l'aide d'une irradiation par des faisceaux ioniques par pulvérisation cathodique-attaque chimique, alors que la bande se trouve dans ladite chambre à vide entre l'entrée étanche et ledit niveau de métal de placage,
faire passer la bande d'acier activée depuis ladite sortie de chambre à vide directement dans ledit bain de placage pour la mettre en contact avec ledit métal de placage, et
ensuite, enlever dudit bain de placage la bande d'acier plaquée.

2. Procédé selon la revendication 1, dans lequel ladite bande d'acier est chauffée à une température convenant à un revêtement par immersion à chaud, et est ensuite introduite, à l'état activé et chauffé, dans ledit bain de placage.

3. Procédé selon la revendication 1 ou 2, dans lequel les faisceaux ioniques dérivent d'argon gazeux ionisé.

4. Procédé selon l'une quelconque des revendications précédentes, dans lequel la bande d'acier comprend sur sa surface au moins l'un des oxydes suivants : oxyde de chrome, oxyde de silicium et oxyde d'aluminium.

5. Procédé selon l'une quelconque des revendications précédentes, dans lequel la bande d'acier est constituée d'acier inoxydable.

6. Appareil pour le revêtement par immersion à chaud d'une bande d'acier, comprenant :
une chambre à vide qui est définie par une entrée étanche à une extrémité supérieure de celle-ci qui est adaptée pour recevoir et délivrer une bande d'acier et une partie de sortie à l'extrémité inférieure de celle-ci, ladite partie de sortie étant immergée en dessous du niveau du métal de placage se trouvant dans un bain de placage,
des moyens d'évacuation reliés à ladite chambre entre ladite entrée étanche et ladite sortie,
ladite chambre étant configurée de façon à permettre à une bande d'acier de se déplacer vers le bas au travers de ladite chambre à vide et de venir en contact avec ledit métal de placage en passant à travers ladite partie de sortie,
des moyens d'éjection de faisceaux ioniques disposés dans ladite chambre à vide au-dessus de ladite partie de sortie, capables de faire subir une pulvérisation cathodique-attaque chimique à au moins une surface de ladite tôle d'acier par irradiation de celle-ci avec des faisceaux ioniques, et
la configuration de la chambre à vide, de la partie de sortie et du bain de placage étant telle que, lors de l'application d'un vide dans ladite chambre, le métal de placage est forcé de s'élever dans ladite partie de sortie pour séparer de l'atmosphère l'intérieur de ladite chambre à vide.

7. Appareil selon la revendication 6, dans lequel une paire de dispositifs d'éjection de faisceaux ioniques sont présents sur les côtés opposés de la chambre à vide pour activer les surfaces opposées d'une tôle d'acier au cours de son déplacement à l'intérieur de ladite chambre à vide.

8. Appareil selon la revendication 6 ou 7, dans lequel des moyens de chauffage sont de plus présents pour chauffer une bande métallique à une température convenant à une immersion à chaud.
